Europäisches Patentamt

European Patent Office

Office européen des brevets

(11) Numéro de publication: **0 451 001 B1**

(12) **FASCICULE DE BREVET EUROPEEN**

(45) Date de publication de fascicule du brevet: **21.09.94**

(51) Int. Cl.5: **C30B 29/22**, H01S 3/16, C30B 11/00, C30B 15/00

(21) Numéro de dépôt: **91400665.5**

(22) Date de dépôt: **11.03.91**

(54) **Oxydes mixtes de strontium et de lanthanide et laser utilisant des monocristaux de ces oxydes.**

(30) Priorité: **13.03.90 FR 9003180**

(43) Date de publication de la demande:
**09.10.91 Bulletin 91/41**

(45) Mention de la délivrance du brevet:
**21.09.94 Bulletin 94/38**

(84) Etats contractants désignés:
**AT BE CH DE DK ES FR GB GR IT LI LU NL SE**

(56) Documents cités:
**EP-A- 0 043 776**
**EP-A- 0 227 499**
**EP-A- 0 250 305**
**EP-A- 0 252 784**

**J. CRYSTAL GROWTH, vol. 85, 1987, pages 234-239, Amsterdam, NL; C.D. BRANDLE etal.: "Czochralski growth and evalation of LaMgAl11O19 based phosphors"**

(73) Titulaire: **OUARTZ ET SILICE**
**"Les Miroirs"**
**18 avenue d'Alsace**
**F-92400 Courbevoie (FR)**

(72) Inventeur: **Alablanche, Sylvie**
**43 rue de Vasco de Gama**
**F-75015 Paris (FR)**
Inventeur: **Benitez, Jean-Marie**
**567 rue de la Gare**
**F-77630 Barbizon (FR)**
Inventeur: **Collongues, Robert**
**7 rue de Fontenay**
**F-92340 Bourg la Reine (FR)**
Inventeur: **Thery, Jeanine**
**15 rue Poliveau**
**F-75005 Paris (FR)**
Inventeur: **Vivien, Daniel**
**6Bis, rue de Kronstadt**
**F-92380 Garches (FR)**

(74) Mandataire: **Mongrédien, André et al**
**c/o SOCIETE DE PROTECTION DES INVENTIONS**
**25, rue de Ponthieu**
**F-75008 Paris (FR)**

## Description

La présente invention a pour objet des oxydes mixtes de strontium et de lanthanide monophasés ayant la structure cristalline de la magnétoplombite, obtenus en particulier sous forme de monocristaux.

Elle trouve une application dans le domaine des microlasers pour l'optique intégrée, les télécommunications par fibres optiques, la médecine (microchirurgie, traitement de la peau) et pour l'étude des semiconducteurs ainsi que dans le domaine des lasers de puissance émettant dans l'infrarouge (1000 à 3000nm) ou le visible permettant notamment d'effectuer des traitements de matériaux (soudures, perçages, marquages, traitements de surface), des réactions photochimiques, la fusion thermonucléaire contrôlée ou la polarisation des atomes d'un gaz tel que l'hélium.

Ces lasers émettent à une ou plusieurs longueurs d'onde discrètes avec un certain degré d'accordabilité.

De façon plus précise, les oxydes mixtes de l'invention sont des aluminates ou des gallates.

Comme aluminates mixtes de lanthanide, de structure magnétoplombite, on connaît des aluminates de lanthane-néodyme-magnésium, appelés LNA de formule chimique $La_{1-x}Nd_xMgAl_{11}O_{19}$ avec $0<x\leq1$ et en particulier $x=0,1$. Ces aluminates ont fait l'objet des brevets FR-A-2 448 134 et EP-A-0 043 776, et de la publication de D. Schearer et al., IEEE Journal of Quantum Electronics, vol. QE-22, n°5, 1986, p. 713-717, "LNA : a neu CW Nd laser tunable around 1,05 and 1,08$\mu$m".

Ces aluminates mixtes obtenus sous forme monocristalline présentent des propriétés optiques comparables à celles que possèdent le grenat d'yttrium et d'aluminium dopé au néodyme, connu sous l'abreviation YAG:$Nd^{3+}$, et l'ultraphosphate de néodyme ($NdP_5O_{14}$) ; ces lasers émettent aussi dans l'infrarouge.

En particulier, le LNA présente des longueurs d'onde d'émission laser à 1054 et 1082nm, encadrant celle du YAG à 1064nm. En outre, il présente un autre domaine de longueur d'onde d'émission autour de 1320nm, domaine correspondant à la plus faible atténuation par les fibres optiques en silice, permettant ainsi la transmission par fibres optiques d'un maximum d'informations avec un minimum de perte.

Toutefois, la fabrication de ces aluminates sous forme de monocristaux, et en particulier par la méthode Czochralski la plus couramment utilisée dans l'industrie, peut conduire à des cristaux de qualité insuffisante dès qu'il s'agit d'atteindre les grandes dimensions requises par l'industrie des lasers de puissance.

De plus, la croissance de ces cristaux se fait naturellement selon la direction cristallographique a. Or, la direction cristallographique c, correspondant à l'axe optique du cristal est beaucoup plus intéressante pour les propriétés laser et conduit à des rendements plus élevés.

En outre, l'utilisation d'un cristal dont l'axe cristallographique c est confondu avec l'axe optique du laser permet une meilleure évacuation de la chaleur et donc un meilleur refroidissement du barreau émetteur que lors de l'utilisation d'un cristal dont l'axe cristallographique a est confondu avec l'axe optique ; ceci tient au fait que la conductivité thermique est anisotrope ; elle est plus élevée dans la direction a que dans la direction c.

Pour obtenir un barreau de LNA orienté selon la direction c, on effectue alors une croissance Czochralski selon la direction a, puis on effectue un prélèvement (ou carottage) du barreau obtenu, selon l'axe c. Ceci complique quelque peu la fabrication de l'émetteur laser.

En outre, l'utilisation d'un barreau orienté selon l'axe c permet une montée en puissance, du fait de l'évacuation de chaleur améliorée.

Le faible rendement de l'émission laser du LNA, indépendamment des problèmes de croissance de ce dernier est dû essentiellement au phénomène d'auto-extinction limitant ainsi la quantité de néodyme responsable de l'effet laser, que l'on peut introduire dans le cristal sans nuire à la fluorescence. Dans le LNA, la quantité maximale d'ions néodyme que l'on peut itroduire est égale à $10^{21}$ ions $Nd^{3+}/cm^3$, ce qui correspond à $x=0,25$, le maximum d'intensité laser étant obtenu pour x voisin de 0,1.

Dans le LNA, le néodyme peut occuper 3 sites cristallins de la structure (confer l'article de D. Shearer ci-dessus), ce qui signifie que cette dernière présente des défauts, gênant en particulier la propagation de la chaleur et donc la montée en puissance du laser. En outre, la présence de plusieurs sites pour le néodyme favorise l'auto-extinction.

La substitution partielle de l'aluminium dans le LNA par le gallium en vue d'améliorer le rendement de l'émission laser, par augmentation de la quantité de néodyme dans la structure, a en particulier été décrite dans le document FR-A-2 599 733. Toutefois, la fabrication des monocristaux correspondants souffre de divers inconvénients (existence de bulles, défauts) dus principalement à la non congruence de la fusion.

Comme autre oxyde d'aluminium connu, on peut citer l'aluminate de strontium dopé au néodyme de formule $SrAl_{12}O_{19}$:$Nd^{3+}$ . Cet oxyde a fait l'objet d'une publication de Kh. S. Bagdasarov et al. "Stimulated emission of $Nd^{3+}$ ions in an $SrAl_{12}O_{19}$ crystal at the transitions $^4F_{3/2} \longrightarrow {}^4I_{11/2}$ and $^4F_{3/2} \longrightarrow {}^4I_{13/2}$" Sov.

Phys. Dokl ; vol. 19 ; N°6, de décembre 1974, pp. 350.

Les ions néodyme dans cet oxyde de strontium peuvent occuper plusieurs sites, limitant ainsi la puissance d'émission laser. De plus, les cristaux obtenus présentent des qualités insuffisantes pour leur utilisation dans l'industrie des lasers et en particulier des lasers de puissance. En outre, la quantité de néodyme que l'on peut introduire dans cet oxyde de strontium est très faible, ce qui contribue encore à la limitation de la puissance laser.

On connâit aussi, par le document US-A-4 441 049, des gallates mixtes de lanthane-magnésium contenant du strontium, dopés au manganèse présentant des propriétés luminescentes, mais pas d'effet laser. Ces gallates sont utilisés en particulier pour l'éclairage fluorescent. En outre, ils se présentent uniquement sous forme de poudre.

Des aluminates de gadolinium-magnésium-strontium, dopés au cérium, obtenus sous forme pulvérulente et présentant aussi des propriétés luminescentes mais pas d'effet laser sont divulgués par le document FR-A-2 442 264.

L'invention a pour objet de nouveaux oxydes mixtes de strontium et de lanthanide utilisables comme émetteurs lasers permettant notamment de remédier aux différents inconvénients donnés ci-dessus.

En particulier, ces nouveaux oxydes peuvent être réalisés sous forme de monocristaux de grandes dimensions, exempts de bulles et de défauts, par la méthode Czochralski, présentant une émission laser dont le rendement est supérieur à celui des aluminates mixtes de néodyme cités précédemment. Ainsi, ces oxydes peuvent être utilisés dans l'industrie des lasers de puissance.

Par ailleurs, ces oxydes de strontium croissent naturellement selon la direction cristallographique $\underline{c}$, ce qui leur confère des propriétés thermiques améliorées, facilitant leur montée en puissance.

De plus, ces oxydes admettent une plus grande quantité d'ions activateurs, contrairement au LNA ou à l'oxyde de strontium dopé au néodyme, mentionnés ci-dessus, sans nuire à l'effet laser, allant encore dans le sens de l'augmentation de la puissance lumineuse émise.

De façon plus précise, l'invention a pour objet des oxydes mixtes de strontium et de néodyme, monophasés ayant une structure du type magnétoplombite, présentant la formule (I) :

(I)    $Sr_xLn1_{y1}Ln2_{y2}Ln3_{y3}M_zA_aB_bO_{19-k}$

dans laquelle Ln1 représente au moins un élément trivalent choisi parmi le lanthane, le gadolinium et l'yttrium ; Ln2 représente au moins un élément trivalent choisi parmi le néodyme, le praséodyme, l'erbium, l'holmium et le thulium ; Ln3 représente au moins un élément choisi parmi l'europium bivalent et le cérium trivalent avec conservation de la neutralité électrique grâce à des lacunes d'oxygène ; M représente au moins un métal bivalent choisi parmi le magnésium, le manganèse et le zinc ; A représente au moins un métal trivalent choisi parmi l'aluminium et le gallium ; B représente au moins un métal de transition trivalent choisi parmi le chrome et le titane ; x, y1, y2, y3, z, a, b et k représentent des nombres tels que $0<x<1$, $0\leq y1<1$, $0<y2<1$, $0\leq y3<1$, $0<z<1$, $10,5<a<12$, $0\leq b\leq0,5$ et $0\leq k\leq1$ à condition que $0<x+y1+y2+y3\leq1$ et que $11<z+a+b\leq12$.

Comme indiqué précédemment, k permet d'assurer la conservation de la neutralité électrique.

Lorsque Ln3 représente l'europium divalent, la conservation de la neutralité électrique est assurée par la relation : $2x+3(y1+y2)+2y3+2z+3(a+b)=2(19-k)$.

Dans tous les autres cas, la conservation électrique est assurée par la relation suivante :

$$2x+3(y1+y2+y3)+2z+3(a+b)=2(19-k).$$

Les composés de l'invention peuvent être fabriqués sous forme de monocristaux.

De préférence, $x+y1+y2+y3$ satisfait à l'équation $0,5\leq x+y1+y2+y3\leq1$.

Ces oxydes mixtes présentent des propriétés mécaniques voisines de celles de l'alumine. En outre, leur structure cristalline est beaucoup plus proche de celle de la magnétoplombite, améliorant ainsi leur propriétés thermiques par rapport aux aluminates mixtes de lanthanide connus précités. Plus la quantité de strontium est élevée dans les composés de l'invention, plus on se rapproche de la structure de la magnéplombite.

De préférence, x satisfait à la relation $0,05\leq x\leq0,95$ ou mieux encore à la relation $0,2\leq x\leq0,95$ et z satisfait à la relation $0,05\leq z\leq0,8$.

Ces oxydes ont une structure hexagonale qui se compose de blocs spinelles séparés par des plans miroirs contenant le strontium et les lanthanides.

Dans les oxydes de l'invention, Ln1 est un ion lanthanide jouant le rôle de diluant ; Ln2 est l'ion lanthanide responsable de l'effet laser, appelé activateur laser, et Ln3 est l'ion lanthanide servant de sensibilisateur laser. De même, l'ion B sert de sensibilisateur laser.

Contrairement aux aluminates mixtes de lanthanide connus, cités précédemment, l'ion activateur laser peut être introduit à des taux très importants dans la structure, augmentant ainsi la puissance d'émission laser.

Par exemple y1, y2 et y3 satisfont aux relations $0 \leq y1 \leq 0,9$ ; $0,02 \leq y2 \leq 0,6$ et $0 \leq y3 \leq 0,6$. De préférence on choisit $0,05 \leq y2 \leq 0,45$ ou mieux encore $0,15 \leq y2 \leq 0,25$ pour une bonne efficacité laser.

Les oxydes de l'invention peuvent être utilisés comme émetteurs lasers dans une grande gamme de longueurs d'onde, ces dernières dépendant de la nature de l'ion activateur. Aussi, l'invention a encore pour objet un laser comportant comme émetteur laser un oxyde tel que décrit précédemment.

Lorsque dans la formule (I), Ln2 représente le néodyme, les oxydes mixtes correspondants, réalisés sous forme de monocristaux, peuvent être utilisés comme émetteurs lasers, en particulier dans des lasers de puissance, émettant à 1049,8nm, 1061,8nm avec une plage d'accordabilité relativement étroite, de l'ordre de 2nm. En outre, ces oxydes au néodyme présentent un type d'émission beaucoup plus large autour de 1074nm qui s'étend de 1066nm à 1078nm, soit sur 12 nanomètres, ce qui est considérable pour un laser solide au néodyme.

Les longueurs d'onde d'émission d'un oxyde mixte au néodyme de l'invention sont différentes de celles du LNA ainsi que de celles décrites dans l'article de Bagdasarov cité précédemment. De plus, les oxydes de néodyme de l'invention sont accordables en longueur d'onde.

Lorsque dans la formule (I), Ln2 représente l'holmium, les oxydes mixtes correspondants, sous forme monocristalline, peuvent être utilisés comme émetteurs lasers en particulier dans les lasers de puissance accordables, émettant dans l'infrarouge et plus spécialement à des longueurs d'onde allant de 1500 à 3000nm.

L'accordabilité permet en particulier dans le domaine des télécommunications, de véhiculer un plus grande nombre d'informations simultanément.

Les longueurs d'onde au voisinage de 3000nm ont l'avantage d'être absorbées par l'eau. En outre, au voisinage de 1500nm, l'oeil n'est plus sensible à l'émission laser et il s'ensuit une sécurité pour ce dernier.

Avec le thulium ou l'erbium pour Ln2 dans la formule (I), on peut obtenir des lasers de puissance ou des microlasers émettant encore dans l'infrarouge, avec une certaine accordabilité.

Lorsque Ln2 représente le praséodyme, les oxydes mixtes correspondants, sous forme monocristalline, peuvent être utilisés comme émetteurs lasers émettant dans le visible et principalement dans le jaune et le rouge, avec encore une certaine accordabilité.

Les lasers utilisant les oxydes monocristallins de l'invention peuvent être aussi bien des lasers pulsés que des lasers émettant en continu. Lorsque ces lasers sont des lasers de puissance, le faisceau lumineux émis présente une puissance émise allant de plusieurs watts à quelques centaines de watts.

Pour réaliser le peuplement de l'état excité E1 où s'effectue l'inversion de population, on excite les ions activateurs jusqu'à un niveau d'énergie E2 supérieur à l'état excité E1 ; le peuplement de l'état E2 est obtenu par absorption de lumière, appelé pompage optique. Le niveau d'énergie E2 étant très instable, les ions luminescents se désexcitent spontanément jusqu'à l'état d'énergie E1. Le passage de l'état E1 au fondamental E0 correspond à l'émission laser.

Etant donné que les pics d'absorption des lanthanides et en particulier du néodyme et du praséodyme sont très étroits, la substitution partielle de l'aluminium ou du gallium par du chrome ou du titane favorise l'absorption de lumière, ces ions présentant dans le visible des bandes d'absorption larges.

De même, la substitution partielle du strontium par le cérium trivalent ou l'europium divalent favorise aussi le pompage optique, ces éléments présentant des bandes d'absorption aussi larges que celles du chrome ou du titane.

Après avoir porté à l'état excité, par absorption de lumière, l'une ou l'autre des bandes spectrales des ions sensibilisateurs, ces derniers transfèrent leur énergie aux ions activateurs assurant ainsi le peuplement du niveau d'énergie E1. Cette transmission d'énergie est possible car la différence d'énergie entre l'état fondamental et l'état excité des ions chrome, titane, cérium ou europium est voisine de la différence d'énergie entre l'état fondamental et l'état surexcité E2 des ions néodyme ou praséodyme, mais aussi des ions erbium, thulium et holmium.

Les sensibilisateurs et les activateurs lasers sont choisis en fonction de la longueur d'onde utilisée pour le pompage optique et de la longueur d'onde d'émission souhaitée. Dans le cas du néodyme ou du praséodyme, un codopage cérium-chrome peut être envisagé favorablement.

Etant donné que la durée de vie de l'état excité E1 décroît lorsque la quantité en ions lumineux croît et qu'inversement l'intensité de fluorescence augmente lorsque la quantité d'ions luminescents croît, les monocristaux pour lesquels y2 est faible sont plus particulièrement adaptés à la réalisation de lasers de puissance fonctionnant en continu alors que les monocristaux pour lequel y2 est plus important sont mieux

4

adaptés à la fabrication de lasers de puissance fonctionnant en impulsions.

En particulier, pour un laser à émission continue, la quantité optimum d'ions activateurs dans un cristal donné est égale à celle qui donne le maximum d'intensité lumineuse, alors que pour un laser impulsionnel, la quantité d'ions activateurs peut être supérieure à cette quantité optimum.

Lors de l'utilisation d'un sensibilisateur, le temps de transfert de l'énergie du sensibilisateur aux ions activateurs doit être compatible avec celui de l'émission de l'activateur. En mode pulsé, un temps de transfert trop long peut être gênant, alors qu'en régime continu ce temps de transfert n'a pas d'importance étant donné que le pompage est assuré en continu.

Aussi, le chrome ayant un temps de transfert assez long est utilisé de préférence comme sensibilisateur pour un laser fonctionnant en continu ; en revanche, le cérium ou l'europium peuvent être utilisés dans un laser fonctionnant en régime pulsé.

La présence d'un métal bivalent tel que le magnésium, le manganèse ou le zinc favorise considérablement la cristallogénèse des oxydes de strontium et permet en particulier, pour une même quantité d'ions activateurs, l'obtention de cristaux de plus belle qualité que celle obtenue avec des oxydes de strontium sans métal divalent ($SrAl_{12}O_{19}$:Nd en particulier). La croissance de ces cristaux est congruente. De plus, ce métal bivalent permet l'introduction d'un plus grand taux d'activateur que celui du même cristal exempt de ce métal divalent.

En général, la quantité de métal divalent est voisine, voire même égale à la quantité de lanthanide.

La présence du strontium dans les oxydes de l'invention assure, pour la méthode Czochralski, une croissance cristalline selon l'axe cristallographique $\underline{c}$ même en l'absence de germe monocristallin. Ceci permet de monter en puissance et d'effectuer un refroidissement du barreau émetteur latéralement, selon la direction cristallographique $\underline{a}$, nécessaire pour éviter que le barreau se transforme en lentille thermique, focalisant la lumière et empêchant ainsi l'effet laser.

De plus, pour une concentration importante de strontium, on obtient un seul site cristallin pour l'ion activateur, contrairement aux oxydes mixtes connus, limitant ainsi les problèmes d'autoextinction et permettant donc d'augmenter la puissance du laser à concentration égale d'ions activateurs.

Le strontium et le gallium des oxydes de l'invention permettent, par rapport au LNA, d'abaisser la force du champ cristallin au site de l'activateur et en particulier du néodyme, d'augmenter la distance activateur-oxygène et donc de réduire le phénomène d'auto-extinction. Ils permettent aussi d'augmenter la quantité d'ions activateur dans le cristal, par rapport au LNA.

La composition des oxydes de l'invention varie de l'aluminate pur au gallate pur, toutes les compositions alumino-gallate intermédiaires pouvant être envisagées.

Les oxydes mixtes de l'invention présentent en particulier la formule (I) dans laquelle M représente le magnésium et A représente l'aluminium. Les oxydes correspondants présentent alors la formule :

$$Sr_xLn1_{y1}Ln2_{y2}Ln3_{y3}Mg_zAl_aO_{19-k}.$$

L'utilisation simultanée du strontium et d'un lanthanide jouant le rôle de diluant permet de modifier la composition du cristal et d'ajuster la longueur d'onde d'émission du cristal laser. Ainsi, il est possible d'adapter la longueur d'onde d'énission en fonction de l'application envisagée.

En particulier, les oxydes de l'invention présentent la formule :

$$Sr_xLn1_{y1}Ln2_{y2}Mg_zA_aO_{19-k}.$$

En faisant varier y2/y1 d'une part et (y1+y2)/x d'autre part, on peut optimiser simultanément plusieurs propriétés du matériau telles que par exemple l'intensité de l'émission laser et sa longueur d'onde. Une telle latitude dans l'optimisation du matériau n'existe pas pour le LNA et l'aluminate de Bagdasarov et al.

D'autres caractéristiques et avantages de l'invention ressortiront mieux de la description qui va suivre, donnée à titre purement illustratif et non limitatif, en référence aux dessins annexés, dans lesquels :

- la figure 1 est un diagramme donnant la puissance (P') en watts émise par un laser conforme à l'invention en fonction de la puissance (P) de pompage d'un laser à argon ionisé, exprimée en watts,
- la figure 2 représente une courbe d'accordabilité donnant la puissance (P) émise, exprimée en watts en fonction de la longueur d'onde exprimée en nm pour un émetteur laser d'un oxyde de formule initiale (II) :

(II)   $Sr_{0,8}Nd_{0,2}Mg_{0,2}Al_{11,8}O_{19}$,

- La figure 3 représente schématiquement le spectre de fluorescence à 300K de l'oxyde de l'invention de formule (II),
- la figure 4 représente schématiquement un laser de puissance fonctionnant en continu utilisant un monocristal d'un oxyde conforme à l'invention,
- la figure 5 représente schématiquement un laser pulsé de puissance utilisant un monocristal d'un oxyde conforme à l'invention,
- la figure 6 donne une portion du spectre d'absorption du monocristal de formule (II) initiale en fonction de la longueur d'onde exprimée en nanomètres, et
- la figure 7 est un diagramme donnant la puissance (P') en watts émise par un laser conforme à l'invention en fonction de la puissance (P) de pompage d'une diode laser, exprimée en watts.

On décrit ci-après la fabrication d'un monocristal d'un oxyde mixte conforme à l'invention, utilisant la technique du four à concentration de rayonnement, connue aussi sous le nom de technique de la zone flottante.

A cet effet, les poudres du commerce, de haute pureté, des oxydes de Ln1, Ln2, Ln3, M, A, B ainsi que du carbonate de strontium sont pesées dans les proportions désirées, mélangées plusieurs heures à l'aide d'un agitateur mécanique puis aises sous forme de pastilles que l'on chauffe à 1100°C pendant 15 heures pour éliminer les carbonates et effectuer une préréaction.

Les pastilles sont ensuite broyées puis remélangées et des barreaux parallélépipédiques de 5cm de long pour 1cm de côté sont formés par compression. Ceux-ci sont alors frittés 50 heures entre 1400 et 1600°C jusqu'à formation d'une solution solide, puis taillés en forme de cylindres pour être utilisés dans le four à concentration de rayonnement. La température de frittage est fonction de la composition exacte du cristal et son choix est à la portée de l'homme de l'art.

Les compositions ont été testées pour des vitesses de translation des barreaux comprises entre 0,4 et 3,5cm/h.

La technique dite du second passage a également été pratiquée : un barreau fritté est fondu une première fois au four à concentration de rayonnement de manière rapide (1,5 à 3,5cm/h) pour faire fondre la poudre et se rapprocher de la densité théorique. Le barreau obtenu est alors fondu une seconde fois lentement à une vitesse de 0,4 à 1cm/h.

Cette méthode de croissance a l'avantage d'être propre (le cristal ne peut être pollué puisque la zone fondue n'est pas en contact avec un creuset), et d'être rapide puisque quelques heures, selon la vitesse de translation utilisée, suffisent pour obtenir un cristal.

Des monocristaux d'oxydes conformes à l'invention ont aussi été obtenus par la technique de croissance Czochralski. A cet effet, des poudres du commerce, de haute pureté, des oxydes Ln1, Ln2, Ln3, M, A, B et du carbonate de strontium pesées dans les proportions désirées sont mélangées plusieurs heures à l'aide d'un agitateur mécanique puis comprimées sous forme de cylindres. Un frittage de 15 heures à 1100°C puis 50 heures entre 1400°C et 1600°C est effectué.

Le mélange fritté est placé dans un creuset d'iridium et amené à la température de fusion. Le tirage s'effectue sous atmosphère d'azote à partir d'une tige d'iridium ou d'un germe ayant l'orientation voulue.

La vitesse de tirage varie de 0,5 à 1mm par heure. La vitesse de rotation varie autour de 30 tours par minute.

Ces méthodes de tirage permettent aussi de travailler sous atmosphère contrôlée (inerte ou oxydante) si nécessaire, notamment dans le cas de composés contenant du gallium.

Les oxydes et carbonates de départ utilisés se présentent sous la forme d'une poudre ayant une granulométrie allant de 1 à 10 micromètres et une pureté supérieure à 99,99% afin d'obtenir un rendement aussi élevé que possible pour l'émission laser. Bien entendu, il est possible d'utiliser d'autres produits de départ comme par exemple des nitrates, comme décrit dans le document FR-A-2 599 733, ou même des chlorures.

Lorsque les monocristaux élaborés contiennent du titane, il est possible d'effectuer un recuit final au four à 1100°C sous atmosphère réductrice de façon à ce que le titane contenu dans la structure soit à l'état d'oxydation (III), cet élément existant dans le commerce à l'état d'oxydation IV sous forme de $TiO_2$.

Bien entendu, tout autre méthode de cristallogénèse utilisant un bain fondu telle que la méthode de Bridgmann, de Kyropoulos, de l'auto-creuset ou de Verneuil peut être utilisée.

De nombreuses compositions de rapports Sr/Ln2 différents, avec Ln2 représentant le néodyme ou le praséodyme, ont été élaborées sous forme monocristalline dans un four à concentration de rayonnement et leurs propriétés optiques telles que l'absorption et la fluorescence ont été étudiées.

Le tableau I annexé donne des exemples de monocristaux d'aluminates et/ou de gallates de strontium-lanthanide-magnésium obtenus au four à concentration de rayonnement. La partie gauche de ce tableau donne la composition en mole % initiale à partir de laquelle ont été fabriqués les barreaux frittés, la partie centrale du tableau donne la formule du cristal obtenu par fusion de zone et la partie droite du tableau donne les paramètres cristallins de ce cristal.

Les tableaux II et III annexés donnent des exemples de monocristaux d'aluminates de strontium-lanthanide-magnésium obtenus respectivement par tirage Czochralski et selon la méthode de Verneuil. Dans ces tableaux II et III la partie gauche donne la composition en mole % de la poudre de départ à partir de laquelle est obtenu le monocristal, la partie centrale donne la formule du monocristal obtenu et la partie droite donne les paramètres cristallins du monocristal.

Les compositions des cristaux obtenus ont été déterminées à la microsonde électronique, à l'exception des compositions précédées d'un astérisque qui n'ont pas encore pu être déterminées précisément, et les paramétres cristallins ont été déterminés par diffraction des rayons X.

De cette étude, il ressort que la composition correspondant à $Sr/Nd = 4$ est tout à fait intéressante. Cette composition est celle de l'exemple 23 et a fait l'objet d'une étude poussée de ses propriétés laser.

Bien que le tirage Czochralski du composé 23 et aussi des exemples 24 à 26 ait été réalisé à partir d'une tige d'iridium et non d'un germe monocristallin, la perfection cristalline de l'échantillon obtenu est tout à fait convenable dans un large domaine.

L'examen du barreau cristallin obtenu au moyen d'un laser hélium-néon montre l'existence de zones exemptes de centres diffusants.

Un échantillon parfaitement monocristallin a été isolé du cristal 23 - selon Czochralski -, par clivage, de manière à obtenir deux faces rigoureusement parallèles. Il se présente sous forme d'une lame cylindrique de 20mm de diamètre et de 7mm d'épaisseur.

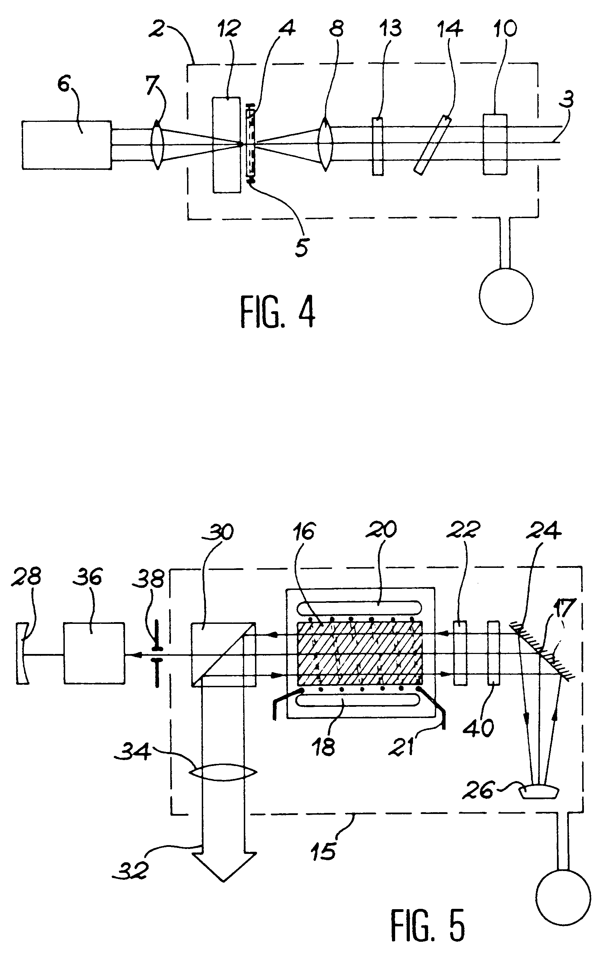

L'axe du cylindre est l'axe $\underline{c}$ de la structure hexagonale et correspond à la direction connue pour être optimale dans le cas du LNA en ce qui concerne l'effet laser. L'échantillon placé dans une cavité laser telle que représentée sur la figure 4, est pompé longitudinalement par la raie verte d'un laser à argon ionisé. A la longueur d'onde utilisée, 514,5nm, l'échantillon absorbe 60% du rayonnement de pompe.

L'effet laser correspondant à la transition $^4F_{3/2} \dashrightarrow {}^4I_{11/2}$ du néodyme est obtenu facilement et se produit spontanément pour une longueur d'onde de 1049,8nm.

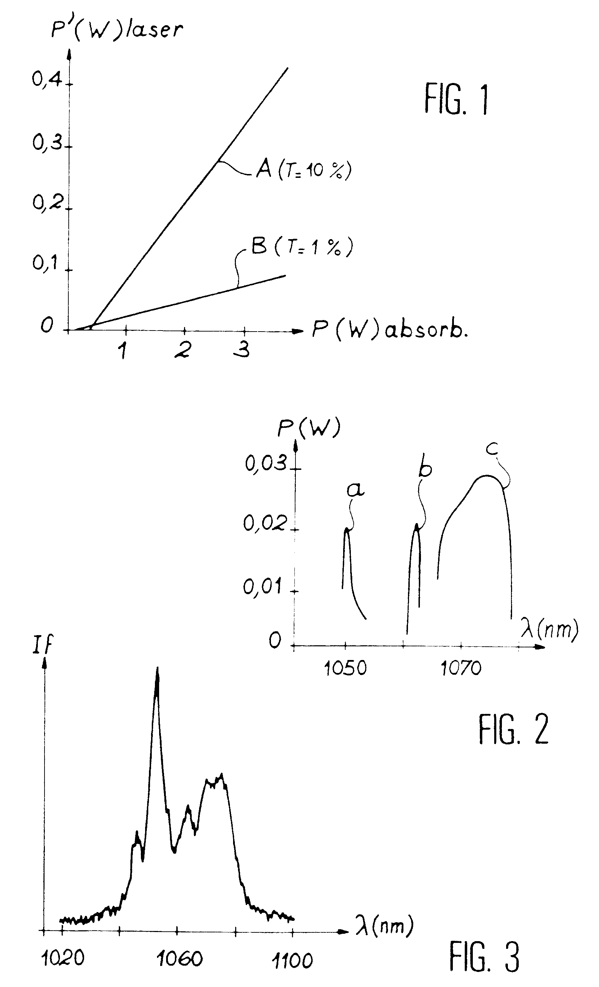

La figure 1 donne deux courbes A et B de rendement de la puissance laser (P') émise par le cristal de composition 23 en fonction de la puissance du laser de pompe à argon ionisé (P) pour deux valeurs de transmission du miroir de sortie de la cavité laser, respectivement 10% et 1%. Si l'on tient compte de la fraction 60% du rayonnement de pompe effectivement absorbée par l'échantillon, on en déduit que le rendement de l'émission laser est de l'ordre de 21% pour un taux de transmission du miroir de 10%, ce qui est relativement élevé.

Par insertion d'un filtre de Lyot (13, figure 4), il est possible de balayer en longueur d'onde l'émission laser. La courbe obtenue est représentée sur la figure 2 ; elle donne la puissance laser (P) en fonction de la longueur d'onde.

Sur cette courbe, on obtient trois maxima d'émission, notés a, b et c, pour respectivement 1049,8nm, 1061,8nm et 1074nm. La plage d'accordabilité autour des deux premières longueurs d'onde est relativement étroite, de l'ordre de 2 nanomètres. En revanche, elle est beaucoup plus large autour du troisième maximum (émission c) puisqu'elle s'étend de 1066nm à 1078nm soit sur 12 nanomètres, ce qui est considérable pour un laser solide au néodyme.

Ces résultats sont en accord avec le spectre de fluorescence de la figure 3, aux intensités If près.

Le spectre de fluorescence de la figure 3 a été établi à 300K ; il a été obtenu en utilisant une longueur d'onde d'excitation de 577nm correspondant à la transition $^4I_{9/2} \dashrightarrow {}^4G_{7/2}, {}^4G_{7/2}$ en absorption du cristal.

Bien que cela n'apparaisse pas sur les courbes de fluorescence et d'accordabilité laser, le composé n°23 ainsi que les composés 1 à 14, 17 à 22 et 24 à 27 activés au néodyme présentent des longueurs d'onde d'émission au voisinage de 1,32 micromètre qui peuvent aussi donner l'effet laser.

Les spectres de fluorescence et d'accordabilité des aluminates de strontium-néodyme-magnésium de l'invention sont très différents de ceux du LNA et du composé de Bagdasarov.

Comme on l'a dit précédemment, il est possible en jouant sur la composition du cristal et en particulier sur la teneur respective en strontium et en lanthanide de déplacer la longueur d'onde d'émission laser.

Ce déplacement en longueur d'onde en fonction de la composition du cristal est donné dans le tableau IV annexé.

Ce tableau IV a été ètabli à partir des spectres de fluorescence à 300K pour des monocristaux élaborés au four à concentration de rayonnement, la transition en émission étant la transition :

$^4F_{3/2} \dashrightarrow {}^4I_{11/2}$ de $Nd^{3+}$.

De ce tableau, il ressort que la longueur d'onde d'émission croît, lorsque la quantité en strontium diminue et que la quantité en néodyme croît.

Le décalage en longueur d'onde a aussi été observé pour l'émission à 1,32µm. En effet, les composés n°1 et n°4 du tableau I émettent de la lumière par fluorescence à respectivement 1,322 et 1,318µm.

Sur la figure 4, on a représenté schématiquement un laser de puissance continu utilisant un monocristal d'un oxyde conforme à l'invention.

Ce laser comprend une cavité laser 2 contenant un barreau 4 du composé 23, disposé perpendiculairement à l'axe longitudinal 3 du laser, l'axe c du barreau étant confondu avec l'axe 3 du laser. L'émission laser correspondante se situe dans l'infrarouge (voir figure 3). L'utilisation des composés 1 à 14, 17 à 22 et 24 à 27 permet le même type d'émission.

Une source de lumière monochromatique 6, telle qu'une diode laser ou une barrette de diodes laser, permet d'irradier le barreau d'aluminate 4, via une lentille de convergence 7, afin d'assurer le pompage optique du barreau 4. Un dispositif 5 de circulation d'eau distillée autour du barreau 4 assure son refroidissement.

La cavité laser 2 se compose aussi d'une lentille convergente 8 transformant la lumière émise par le barreau d'aluminate 4 en un faisceau de lumière parallèle qui est envoyé sur un miroir de sortie 10.

Après réflexion sur ce miroir 10, le faisceau lumineux traverse à nouveau la lentille convergente 8 et le milieu amplificateur ou barreau 4. Le faisceau laser amplifié est alors réfléchi par un miroir d'entrée dichroïque 12 à proximité duquel est placé le barreau 4 ; ce miroir 12 est transparent à la lumière émise par la source monochromatique 6 et opaque à celle émise par le monocristal d'aluminate 4.

Le faisceau laser suffisamment amplifié dans la cavité 2 est alors envoyé vers l'extérieur de la cavité laser, via le miroir 10, qui est partiellement transparent à la lumière émise par le monocristal d'aluminate 4.

Le remplacement du barreau 4 d'aluminate de strontium-néodyme-magnésium par un aluminate selon l'invention de strontium-praséodyme-magnésium tel que le composé 15 ou 16, conduit à un laser de puissance continu émettant dans le visible et en particulier dans le jaune et le rouge.

Il est possible bien entendu d'utiliser un barreau 4 d'aluminate de l'invention au néodyme ou au praséodyme combiné avec du cérium, de l'europium, du chrome ou du titane.

De la même façon, on peut utiliser un barreau d'un oxyde contenant de l'holmium, de l'erbium, du thulium, combinés ou non avec le cérium, l'europium, le titane ou le chrome afin d'obtenir des lasers de puissance émettant dans une grande gamme de longueurs d'onde.

En particulier, l'utilisation d'un oxyde contenant de l'holmium permet l'émission d'un faisceau laser dont la longueur d'onde varie de 1,5 à 3 micromètres suivant la transition choisie.

L'accordabilité en longueur d'onde peut être obtenue à l'aide d'un système de sélection en longueur d'onde 14 intercalé entre la lentille convergente 8 et le miroir de sortie 10 de la cavité laser 2, du type prisme à angle de Brewster ou filtre de Lyot formé de plusieurs lames en matériau biréfringent.

En outre, un étalon solide 13 du type lame à faces parallèles peut être intercalé entre la lentille convergente 8 et le filtre de Lyot 14 pour fixer la longueur d'onde d'émission.

Les oxydes de l'invention peuvent aussi être utilisés sous forme monocristalline dans un laser de puissance fonctionnant en impulsions. Un tel laser est représenté sur la figure 5.

Ce laser pulsé comprend une cavité 15 contenant un barreau monocristallin 16 d'un oxyde selon l'invention, disposé parallélement à l'axe longitudinal 17 du laser, l'axe c du cristal étant confondu avec l'axe 17. Cet oxyde est en particulier le composé 3 ou 1 à forte teneur en néodyme.

De part et d'autre du barreau 16, sont disposées des lampes flash au xénon de forte intensité 18 et 20, de forme allongée, orientées aussi selon l'axe 17 du laser. Ces lampes assurent un pompage optique longitudinal du barreau d'aluminate 16. Un dispositif 21 de circulation d'eau distillée autour du barreau 16 assure son refroidissement.

La cavité laser 15 se compose aussi d'une lame quart d'onde 22 transformant la lumière incidente polarisée linéairement, issue du barreau 16, en une lumière polarisée circulairement. Cette lame 22 est suivie d'un miroir plan 24 et d'un miroir convexe 26 divergent.

Après réflexion sur le miroir 26, le faisceau lumineux élargi, adapté et polarisé circulairement, traverse à nouveau la lame quart d'onde 22 produisant ainsi un faisceau polarisé verticalement qui balaye complètement le milieu amplificateur ou barreau 16, en en extrayant le maximum d'énergie lumineuse.

Le faisceau laser amplifié se propageant dans la direction d'un autre miroir 28 hautement réfléchissant concave extérieur à la cavité 15, est interrompu par un prisme polariseur 30 éjectant le faisceau polarisé verticalement 32 hors de la cavité laser. Une lentille convergente 34 permet l'obtention d'un faisceau de lumière parallèle.

Ce laser pulsé est équipé en outre d'un interrupteur électrooptique 36, plus généralement désigné sous le vocable anglo-saxon de "Q switch", disposé entre le miroir concave 28 et le polariseur de sortie 30.

Lorsque cet interrupteur est fermé, c'est-à-dire qu'une tension lui est appliquée, le laser ne peut fonctionner. En effet, pendant que l'on "pompe" optiquement le milieu amplificateur avec les lampes 18 et 20, le polariseur 30 est transparent aux photons polarisés horizontalement et laisse passer la lumière vers l'interrupteur 36. Celui-ci faisant tourner la direction de polarisation de 90° empêche le polariseur 30 de transmettre cette lumière.

Inversement, lorsqu'on ouvre l'interrupteur èlectrooptique 36, celui-ci n'altère plus la polarisation horizontale issue du polarisateur, permettant ainsi à la cavité laser 15 d'amplifier la lumière émise par le barreau 16.

Un diaphragme 38 peut être intercalé entre l'interrupteur et le polariseur pour canaliser la lumière laser.

Comme précédemment, le barreau 16 à base de néodyme peut être remplacé par un barreau à base de praséodyme, d'holmium, d'erbium, de thulium, combinés ou non avec du cérium, de l'europium, du chrome ou du titane ou un barreau à base de néodyme combiné avec du cériun, de l'europium, du chrome ou du titane, répondant à la formule (I) ci-dessus, en vue d'obtenir d'autres lasers de puissance pulsés. Il convient simplement d'adapter le revêtement des miroirs 26 et 28 à la longueur d'onde d'émission laser recherchée.

Pour obtenir un laser accordable en longueur d'onde, par exemple en utilisant un oxyde selon l'invention contenant de l'holmium ou du néodyme, un dispositif de sélection en longueur d'onde 40 tel que décrit ci-dessus doit être intercalé entre la lame 22 et le miroir 24.

Les lasers décrits ci-dessus n'ont bien entendu été donnés qu'à titre illustratif, d'autres types de lasers pouvant être équipés d'un monocristal d'un oxyde selon l'invention.

En particulier, il est possible de remplacer la barrette de diodes laser 6 par un laser à gaz ionisé (argon ou krypton) ou les lampes flash 18 et 20 par une diode laser ou barrettes de diodes.

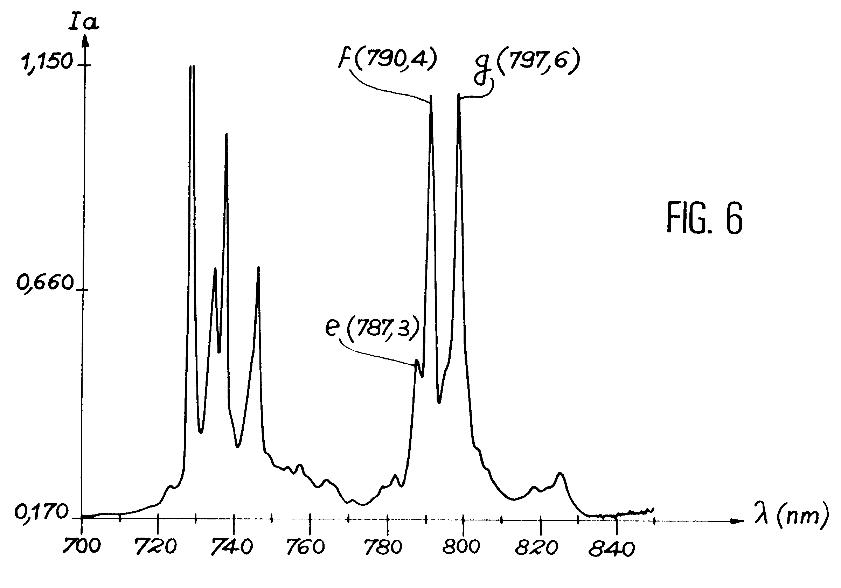

Ces diodes laser ont l'avantage d'être extrêmement petites diminuant de façon considérable les dimensions totales du laser à cristal. En outre, elles offrent une certaine accordabilité en longueur d'onde autour de 800nm. Or, le spectre d'absorption représenté sur la figure 6, pour le composé de formule initiale (II), met en évidence une bande d'absorption large et intense entre 785 et 800nm avec des pics e, f, g à 787,3, 790,4 et 797,6nm. Ce spectre d'absorption a été effectué à 300°K.

L'allure générale de ce spectre d'absorption est valable pour tous les oxydes de l'invention contenant du néodyme ; seules l'intensité et les longueurs d'onde d'absorption peuvent être légèrement différentes. Aussi, les oxydes au néodyme de l'invention se révèlent bien adaptés pour un pompage par diodes laser, d'autant que la longueur d'onde de ces dernières peut être accordée afin de se trouver dans un pic d'absorption maximum du cristal.

Par ailleurs, l'intensité d'absorption autour de 800nm des oxydes de l'invention est deux à trois fois plus forte que celle obtenue à 514nm avec un laser à argon ionisé ou à 752nm avec un laser à krypton ionisé.

En outre, les diodes laser ont un rendement excellent de l'ordre de 50% et la conversion laser est de l'ordre de 30% à 40%, ce qui correspond à un rendement de l'effet laser de 20% au moins à partir du courant électrique.

En utilisant un laser à gaz ou des lampes flash, le rendement laser à partir du courant électrique n'est que de 1%.

Des tests laser obtenus par pompage par diode laser ont été réalisés sur des cylindres de 5 mm de diamètre et 5 mm de hauteur, taillés dans le composé 23 (Sr/Nd = 4) obtenu par tirage Czochralski.

L'effet laser a été observé (pour la transition $^4F_{3/2} \rightarrow ^4J_{11/2}$) selon l'axe $\underline{c}$ du cristal. La puissance maximum de l'effet laser obtenue a été de 190 mW pour 1 watt émis par la diode. On arrive ainsi à un rendement $\rho$ d'effet laser de 33% et un seuil de puissance absorbée de 200 mW pour un miroir de sortie à 2% de transmission et une longueur d'onde de pompe de 799 nm (à 0°C).

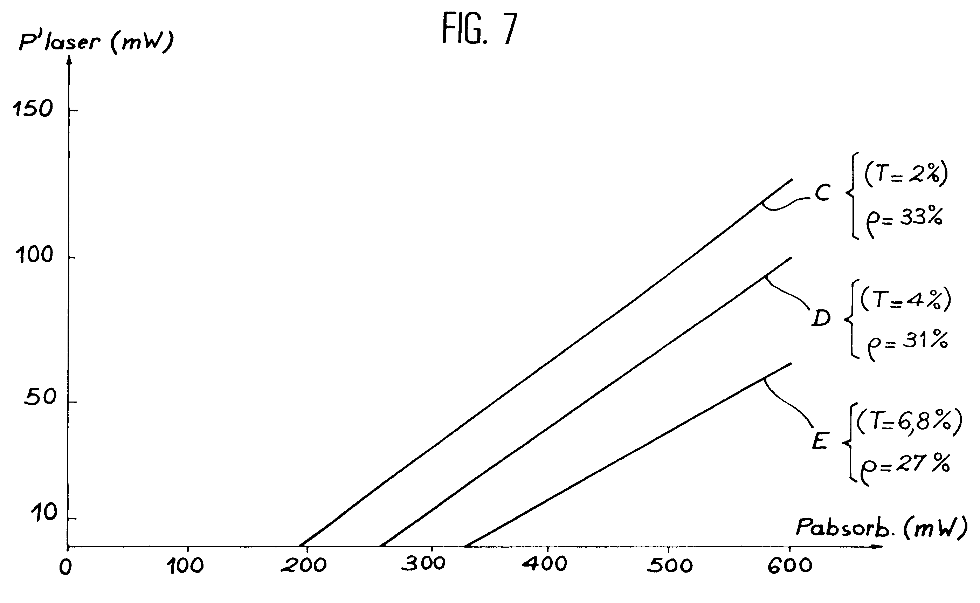

Ceci ressort notamnent de la figure 7 sur laquelle on a représenté trois courbes C, D et E de rendement de la puissance laser (P') émise par le cristal de composition 23 en fonction de la puissance de pompe de la diode, absorbée (P) pour trois valeurs de transmission T du miroir de sortie de la cavité laser, respectivement 2%, 4% et 6,8%. Sur cette figure, les rendements de l'effet laser $\rho$ sont indiqués.

Les monocristaux des oxydes de strontium-néodyme-magnésium de l'invention peuvent être utilisés dans toutes les applications utilisant actuellement un émetteur laser du type YAG. En particulier, ces monocristaux peuvent être utilisés pour des lasers destinés à la découpe ou au marquage de matériaux ainsi que pour réaliser des soudures.

En plus des applications du type YAG, ces oxydes présentent des applications qui leur sont propres. Ils sont particulièrement propices au pompage par diodes laser et donc à la réalisation de dispositifs miniaturisés (applications militaires, recherche scientifique, applications médicales). En outre, leurs longueurs d'onde d'émission particulières et l'accordabilité de ces dernières peuvent être mises à profit dans les télécommunications optiques ou pour la polarisation de certains atomes par pompage optique.

TABLEAU I

EXEMPLES DE MONOCRISTAUX OBTENUS AU FOUR A CONCENTRATION DE RAYONNEMENTS

| EX. | Composition initiale en mole % | | | | Cristal obtenu - Composition - | Paramètres cristallins (nm) | |
|---|---|---|---|---|---|---|---|
| | SrCO$_3$ | Nd$_2$O$_3$ | MgO | Al$_2$O$_3$ | | a | c |
| 1 | 7,143 | 3,571 | 7,143 | 82,143 | $Sr_{0,510}Nd_{0,490}Mg_{0,461}Al_{11,525}O_{19}$ | 0,5577 | 2,195 |
| 2 | 8,571 | 2,857 | 5,714 | 82,857 | $Sr_{0,586}Nd_{0,393}Mg_{0,358}Al_{11,642}O_{19}$ | 0,5573 | 2,199 |
| 3 | 5,714 | 4,286 | 8,571 | 81,429 | $Sr_{0,363}Nd_{0,581}Mg_{0,581}Al_{11,419}O_{18,944}$ | 0,5575 | 2,193 |
| 4 | 11,429 | 1,429 | 2,857 | 84,286 | $Sr_{0,787}Nd_{0,188}Mg_{0,1689}Al_{11,831}O_{18,9844}$ | 0,5568 | 2,199 |
| 5 | 12,857 | 0,714 | 1,429 | 85,000 | $Sr_{0,891}Nd_{0,101}Mg_{0,095}Al_{11,905}O_{19}$ | 0,5570 | 2,200 |
| 6 | 10,000 | 2,143 | 4,286 | 83,571 | $Sr_{0,690}Nd_{0,287}Mg_{0,297}Al_{11,703}O_{18,972}$ | 0,5570 | 2,198 |

| EX. | SrCO$_3$ | Nd$_2$O$_3$ | La$_2$O$_3$ | MgO | Al$_2$O$_3$ | Cristal obtenu - Composition - | a | c |
|---|---|---|---|---|---|---|---|---|
| 7 | 11,429 | 1,071 | 0,357 | 2,857 | 84,286 | $Sr_{0,780}La_{0,045}Nd_{0,150}Mg_{0,186}Al_{11,814}O_{18,9795}$ | 0,5571 | 2,199 |
| 8 | 11,429 | 0,714 | 0,714 | 2,857 | 84,286 | $Sr_{0,728}La_{0,126}Nd_{0,103}Mg_{0,205}Al_{11,795}O_{18,969}$ | 0,5570 | 2,200 |
| 9 | 11,429 | 0,143 | 1,286 | 2,857 | 84,286 | $Sr_{0,791}La_{0,153}Nd_{0,022}Mg_{0,181}Al_{11,819}O_{18,963}$ | 0,5570 | 2,201 |

| EX. | SrCO$_3$ | Gd$_2$O$_3$ | Nd$_2$O$_3$ | MgO | Al$_2$O$_3$ | Cristal obtenu - Composition - | a | c |
|---|---|---|---|---|---|---|---|---|
| 10 | 11,429 | 0,714 | 0,714 | 2,857 | 84,286 | $Sr_{0,749}Gd_{0,098}Nd_{0,100}Mg_{0,183}Al_{11,817}O_{18,9545}$ | 0,5568 | 2,198 |

EP 0 451 001 B1

## T A B L E A U  I (suite)

### EXEMPLES DE MONOCRISTAUX OBTENUS AU FOUR A CONCENTRATION DE RAYONNEMENTS

| EX. | Composition initiale en mole % | | | | | Cristal obtenu - Composition - | Paramètres cristallins (nm) a | c |
|---|---|---|---|---|---|---|---|---|
| | SrCO$_3$ | Nd$_2$O$_3$ | CeO$_2$ | MgO | Al$_2$O$_3$ | | | |
| 11 | 11,420 | 1,356 | 0,143 | 2,855 | 84,225 | $Sr_{0,744}Nd_{0,219}Ce_{0,008}Mg_{0,197}Al_{11,803}O_{18,9845}$ | 0,5571 | 2,200 |
| 12 | 9,286 | 1,071 | 1,429 | 5 | 83,214 | $Sr_{0,633}Nd_{0,134}Ce_{0,206}Mg_{0,303}Al_{11,697}O_{18,9915}$ | 0,5571 | 2,197 |
| | SrCO$_3$ | Nd$_2$O$_3$ | Cr$_2$O$_3$ | MgO | Al$_2$O$_3$ | | | |
| 13 | 11,429 | 1,429 | 0,0857 | 2,857 | 84,200 | $Sr_{0,751}Nd_{0,227}Mg_{0,186}Al_{11,810}Cr_{0,004}O_{19}$ | 0,5570 | 2,199 |
| | SrCO$_3$ | Nd$_2$O$_3$ | TiO$_2$ | MgO | Al$_2$O$_3$ | | | |
| 14 | 11,034 | 1,379 | 6,896 | 2,759 | 77,930 | $Sr_{0,764}Nd_{0,199}Mg_{0,234}Al_{11,695}Ti_{0,071}O_{18,9455}$ | 0,5571 | 2,202 |
| | SrCO$_3$ | Pr$_6$O$_{11}$ | MgO | Al$_2$O$_3$ | | | | |
| 15 | 7,317 | 1,219 | 7,317 | 84,146 | | $Sr_{0,480}Pr_{0,360}Mg_{0,425}Al_{11,575}O_{18,8075}$ | 0,5578 | 2,196 |
| 16 | 11,538 | 0,481 | 2,885 | 85,096 | | $Sr_{0,740}Pr_{0,150}Mg_{0,197}Al_{11,803}O_{18,8665}$ | 0,5570 | 2,200 |
| | SrCO$_3$ | Nd$_2$O$_3$ | MgO | Ga$_2$O$_3$ | Al$_2$O$_3$ | | | |
| 17 | 10,021 | 1,253 | 2,505 | 36,951 | 49,270 | $Sr_{0,784}Nd_{0,162}Mg_{0,146}Ga_{2,110}Al_{9,744}O_{18,954}$ | 0,563 | 2,224 |
| 18 | 8,922 | 1,115 | 2,231 | 43,863 | 43,869 | $*Sr_{0,8}Nd_{0,2}Mg_{0,2}Ga_{3,933}Al_{7,867}O_{19}$ | 0,564 | 2,225 |
| 19 | 11,429 | 1,429 | 2,857 | 28,093 | 56,193 | $*Sr_{0,8}Nd_{0,2}Mg_{0,2}Ga_{3,933}Al_{7,867}O_{19}$ | 0,560 | 2,212 |
| 20 | 11,429 | 1,429 | 2,857 | 42,143 | 42,143 | $*Sr_{0,8}Nd_{0,2}Mg_{0,2}Ga_{5,9}Al_{5,9}O_{19}$ | 0,5645 | 2,228 |
| 21 | 11,429 | 1,429 | 2,857 | 84,286 | – | $*Sr_{0,8}Nd_{0,2}Mg_{0,2}Ga_{11,8}O_{19}$ | – | – |
| | SrCO$_3$ | Nd$_2$O$_3$ | MgO | Cr$_2$O$_3$  Ga$_2$O$_3$ | Al$_2$O$_3$ | | | |
| 22 | 11,429 | 1,429 | 2,857 | 0,086  28,064 | 56,136 | $*Sr_{0,8}Nd_{0,2}Mg_{0,2}Cr_{0,012}Ga_{3,929}Al_{7,859}O_{19}$ | 0,5601 | 2,209 |

* Compositions non encore déterminées par microsonde

EP 0 451 001 B1

T A B L E A U  II
=====================

EXEMPLES DE MONOCRISTAUX OBTENUS PAR TIRAGE CZOCHRALSKI

| EX | Composition initiale en mole % | | | | Cristal obtenu - Composition - | Paramètres cristallins (nm) | |
|---|---|---|---|---|---|---|---|
| | $SrCO_3$ | $Nd_2O_3$ | MgO | $Al_2O_3$ | | a | c |
| 23 | 11,429 | 1,429 | 2,857 | 84,286 | $Sr_{0,741}Nd_{0,229}Mg_{0,205}Al_{11,794}O_{18,981}$ | 0,5571 | 2,198 |
| 24 | 12,143 | 1,071 | 2,143 | 84,643 | $Sr_{0,803}Nd_{0,171}Mg_{0,174}Al_{11,826}O_{18,9725}$ | 0,557 | 2,200 |
| 25 | 10,640 | 1,645 | 2,958 | 84,757 | $*Sr_{0,741}Nd_{0,229}Mg_{0,206}Al_{11,805}O_{19}$ | 0,557 | 2,198 |
| 26 | 8,571 | 2,857 | 5,714 | 82,857 | $*Sr_{0,6}Nd_{0,4}Mg_{0,4}Al_{11,6}O_{19}$ | 0,557 | 2,196 |

T A B L E A U  III
===================

EXEMPLE D'UN MONOCRISTAL OBTENU PAR LA METHODE DE VERNEUIL

| EX | Composition initiale en mole % | | | | Cristal obtenu - Composition - | Paramètres cristallins (nm) | |
|---|---|---|---|---|---|---|---|
| | $SrCO_3$ | $Nd_2O_3$ | MgO | $Al_2O_3$ | | a | c |
| 27 | 11,429 | 1,429 | 2,857 | 84,286 | $Sr_{0,710}Nd_{0,264}Mg_{0,271}Al_{11,729}O_{18,9705}$ | 0,557 | 2,199 |

* Compositions non encore déterminées par microsonde

TABLEAU IV

DEPLACEMENT DES LONGUEURS D'ONDES D'EMISSION EN FONCTION DE LA COMPOSITION

| Composition n° | émission a (nm) | émission b (nm) | émission c (nm) | |
|---|---|---|---|---|
| 1 | 1055 | 1064,2 | - | 1079 |
| 2 | 1053,2 | 1063,4 | 1072,4 | 1076,3 |
| 4 | 1051,3 | 1063,2 | 1069,6 | 1074 |
| 5 | 1050,6 | 1062,4 | 1068,2 | 1073,6 |
| 16 | 1051,1 | 1062 | 1069 | 1073,6 |

**Revendications**

1. Oxyde mixte de strontium et de lanthanide monophasé à structure cristalline du type magnétoplombite, présentant la formule (I) suivante :

13

(I) $Sr_xLn1_{y1}Ln2_{y2}Ln3_{y3}M_zA_aB_bO_{19-k}$

dans laquelle Ln1 représente au moins un élément trivalent choisi parmi le lanthane, le gadolinium et l'yttrium ; Ln2 représente au moins un élément trivalent choisi parmi le néodyme, le praséodyme, l'erbium, l'holmium et le thulium ; Ln3 représente au moins un élément choisi parmi l'europium bivalent et le cérium trivalent avec conservation de la neutralité électrique grâce à des lacunes d'oxygène ; M représente au moins un métal bivalent choisi parmi le magnésium, le manganèse et le zinc ; A représente au moins un métal trivalent choisi parmi l'aluminium et le gallium ; B représente au moins un métal de transition trivalent choisi parmi le chrome et le titane ; x, y1, y2, y3, z, a, b et k représentent des nombres tels que $0<x<1$, $0{\leq}y1<1$, $0<y2<1$, $0{\leq}y3<1$, $0<z<1$, $10,5<a<12$, $0{\leq}b{\leq}0,5$ et $0{\leq}k{\leq}1$ à condition que $0<x+y1+y2+y3{\leq}1$ et que $11<z+a+b{\leq}12$.

2. Oxyde mixte selon la revendication 1, caractérisé en ce que M représente le magnésium.

3. Oxyde mixte selon la revendication 1 ou 2, caractérisé en ce que A représente l'aluminium.

4. Oxyde mixte selon l'une quelconque des revendications 1 à 3, caractérisé en ce que Ln1 représente le lanthane.

5. Oxyde mixte selon l'une quelconque des revendications 1 à 4, caractérisé en ce que Ln3 représente le cérium.

6. Oxyde mixte selon l'une quelconque des revendications 1 à 5, caractérisé en ce que y2 satisfait à la relation $0,02{\leq}y2{\leq}0,6$.

7. Oxyde mixte seton la revendication 1, caractérisé en ce qu'il présente la formule :

$Sr_xLn2_{y2}Mg_zAl_aO_{19-k}$.

8. Oxyde mixte selon l'une quelconque des revendications 1 à 7, caractérisé en ce que Ln2 représente le néodyme.

9. Oxyde mixte selon l'une quelconque des revendications 1 à 7, caractérisé en ce que Ln2 représente le praséodyme.

10. Oxyde mixte selon la revendication 1, caractérisé en ce qu'il présente la formule :

$Sr_xLn1_{y1}Nd_{y2}Mg_zAl_aO_{19-k}$

avec Ln1 représentant le lanthane ou le gadolinium et $y1{\neq}0$.

11. Oxyde mixte selon l'une quelconque des revendications 7 à 10, caractérisé en ce que $k=0$.

12. Oxyde mixte selon l'une quelconque des revendications 1 à 11, caractérisé en ce que $0,5{\leq}x+y1+y2+y3{\leq}1$.

13. Oxyde mixte selon l'une quelconque des revendications 1 à 12, caractérisé en ce que $0{\leq}y1{\leq}0,9$.

14. Oxyde mixte selon l'une quelconque des revendications 1 à 13, caractérisé en ce que $0{\leq}y3{\leq}0,6$.

15. Oxyde mixte selon l'une quelconque des revendications 1 à 14, caractérisé en ce que $0,05{\leq}x{\leq}0,95$.

16. Oxyde mixte selon l'une quelconque des revendications 1 à 15, caractérisé en ce que $0,05{\leq}z{\leq}0,8$.

17. Laser comportant une cavité laser (2, 15) renfermant comme émetteur de lumière un monocristal (4, 16) d'un oxyde mixte de lanthanide, des moyens d'amplification (10, 12, 26, 30) de la lumière issue du monocristalt, des moyens d'extraction (10, 30) de la lumière hors de la cavité laser et des moyens de pompage optique (6, 18, 20), caractérisé en ce que cet oxyde mixte est conforme à l'une quelconque

14

des revendications 1 à 16.

**18.** Laser selon la revendication 17, émettant dans l'infrarouge, caractérisé en ce que Ln2 représente un élément choisi parmi le néodyme, l'holmium, l'erbium et le thulium.

**19.** Laser selon la revendication 17, émettant dans le visible, caractérisé en ce que Ln2 représente le praséodyme.

**20.** Laser selon la revendication 17, accordable en longueur d'onde dans l'infrarouge, comportant des moyens d'accordabilité (14, 40), caractérisé en ce que Ln2 représente un élément choisi parmi le néodyme, l'holmium, le thulium et l'erbium.

**21.** Laser selon l'une quelconque des revendications 17 à 20, caractérisé en ce que $0{,}05 \leq y2 \leq 0{,}45$.

**22.** Laser selon l'une quelconque des revendications 17 à 21, caractérisé en ce que $0{,}15 \leq y2 \leq 0{,}25$.

**23.** Laser selon l'une quelconque des revendications 17 à 22, caractérisé en ce que les moyens de pompage optique (6) consistent en au moins une diode laser.

**24.** Laser selon la revendication 17, caractérisé en ce que Ln2 représente le néodyme et en ce que les moyens de pompage optique (6) consistent en au moins une diode laser émettant vers 800 nm.

**Claims**

**1.** Mixed single-phase strontium and lanthanide oxide with a magnetoplumbite type crystalline structure having the following formula (I):

(I)   $Sr_x \, Ln1_{y1} \, Ln2_{y2} \, Ln3_{y3} \, M_z \, A_a \, B_b \, O_{19-k}$

in which Ln1 represents at least one trivalent element selected from lanthanum, gadolinium and yttrium; Ln2 represents at least one trivalent element selected from neodymium, praseodymium, erbium, holmium and thulium; Ln3 represents an element selected from bivalent europium or trivalent cerium with retention of electric neutrality by virtue of oxygen holes; M represents at least one bivalent metal selected from magnesium, manganese and zinc; A represents at least one trivalent metal selected from aluminium and gallium; B represents at least one trivalent transition metal selected from chromium and titanium; x, y1, y2, y3, z, a, b and k represent numbers so that $0 < x < 1$, $0 \leq y1 < 1$, $0 < y2 < 1$, $0 \leq y3 < 1$, $0 < z < 1$, $10.5 < a < 12$, $0 \leq b \leq 0.5$ and $0 \leq k \leq 1$ provided that $0 < x + y1 + y2 + y3 \leq 1$ and that $11 < z + a + b \leq 12$.

**2.** Mixed oxide according to claim 1, characterized in that M represents magnesium.

**3.** Mixed oxide according to claim 1 or 2, characterized in that A represents aluminium.

**4.** Mixed oxide according to any one of claims 1 to 3, characterized in that Ln1 represents lanthanum.

**5.** Mixed oxide according to any one of claims 1 to 4, characterized in that Ln3 represents cerium.

**6.** Mixed oxide according to any one of claims 1 to 5, characterized in that y2 satisfies the equation $0.02 \leq y2 \leq 0.6$.

**7.** Mixed oxide according to claim 1, characterized in that it has the formula:

$Sr_x \, Ln2_{y2} \, Mg_z \, Al_a \, O_{19-k}$.

**8.** Mixed oxide according to any one of claims 1 to 7, characterized in that Ln2 represents neodymium.

**9.** Mixed oxide according to any one of claims 1 to 7, characterized in that Ln2 represents praseodymium.

15

**10.** Mixed oxide according to claim 1, characterized in that it has the formula:

$$Sr_x \, Ln1_{y1} \, Nd_{y2} \, Mg_z \, Al_a \, O_{19-k}$$

with Ln1 representing lanthanum or gadolinium and y1 ≠ 0.

**11.** Mixed oxide according to any one of claims 7 to 10, characterized in that k = 0.

**12.** Mixed oxide according to any one of claims 1 to 11, characterized in that 0.5 ≤ x + y1 + yy2 + y3 ≤ 1.

**13.** Mixed oxide according to any one of claims 1 to 12, characterized in that 0 ≤ y1 ≤ 0.9.

**14.** Mixed oxide according to any one of claims 1 to 13, characterized in that 0 ≤ 3 ≤ 0.6.

**15.** Mixed oxide according to any one of claims 1 to 14, characterized in that 0.05 ≤ x ≤ 0.95.

**16.** Mixed oxide according to any one of claims 1 to 15, characterized in that 0.05 ≤ z ≤ 0.8.

**17.** Laser comprising one laser cavity (2, 15) containing as the light emitter a monocrystal (4, 16) of a mixed lanthanide oxide, means (10, 12, 26, 30) for amplifying the light derived from the monocrystal, means (10, 30) for extracting the light outside the laser cavity and optical pumping means (6, 18, 20), characterized in that this mixed oxide conforms to any one of claims 1 to 16.

**18.** Laser according to claim 17 and emitting in the infrared spectrum, characterized in that Ln2 represents an element selected from neodymium, holmium, erbium and thullium.

**19.** Laser according to claim 17 and emitting in the visible spectrum, characterized in that Ln2 represents praseodymium.

**20.** Laser according to claim 17 and wavelength-tunable in the infrared spectrum and comprising tunability means, characterized in that Ln2 represents an element selected from neodymium, holmium, thulium and erbium.

**21.** Laser according to any one of claims 17 to 20, characterized in that 0.05 ≤ y2 ≤ 0.45.

**22.** Laser according to any one of claims 17 to 21, characterized in that 0.15 ≤ y2 ≤ 0.25.

**23.** Laser according to any one of claims 17 to 22, characterized in that the optical pumping means consist of at least one laser diode.

**24.** Laser according to claim 17, characterized in that Ln2 represents neodymium and that the optical pumping means consist of at least one laser diode emitting at 800 nm.

**Patentansprüche**

**1.** Strontium und Lanthanid Mischoxid in Monophase mit kristalliner Struktur vom Magnetoplombit-Typ, das durch die folgende Formel (I) dargestellt wird:

(I)    $Sr_x Ln1_{y1} Ln2_{y2} Ln3_{y3} M_z A_a B_b O_{19-k}$

in der Ln1 wenigstens ein dreiwertiges Element darstellt, ausgewählt aus Lanthan, Gadolinium und Yttrium; Ln2 wenigstens ein dreiwertiges Element darstellt, ausgewählt aus Neodym, Praseodym, Erbium, Holmium und Thulium; Ln3 wenigstens ein Element darstellt, ausgewählt aus zweiwertigem Europium und dreiwertigem Cer, wobei elektrische Neutralität aufgrund von Sauerstofflücken beibehalten wird; M wenigstens ein zweiwertiges Metall darstellt, ausgewählt aus Magnesium, Mangan und Zink; A wenigstens ein dreiwertiges Metall darstellt, ausgewählt aus Aluminium und Gallium; B wenigstens ein dreiwertiges Übergangsmetall darstellt, ausgewählt aus Chrom und Titan; x, y1, y2, y3, z, a, b und k Zahlen wie 0<x<1, 0<y1<1, 0<y2<1, 0<y3<1, 0<z<1, 10,5<a<12, 0≦b≦0,5 und 0≦k≦1 darstellen mit

EP 0 451 001 B1

der Maßgabe, daß $0 < x + y1 + y2 + y3 \leq 1$ und daß $11 < z + a + b \leq 12$ ist.

2. Mischoxid nach Anspruch 1, **dadurch gekennzeichnet**, daß M Magnesium darstellt.

3. Mischoxid nach Anspruch 1 oder 2, **dadurch gekennzeichnet**, **daß** A Aluminium darstellt.

4. Mischoxid nach einem der Ansprüche 1 bis 3, **dadurch gekennzeichnet, daß** Ln1 Lanthan darstellt.

5. Mischoxid nach einem der Ansprüche 1 bis 4, **dadurch gekennzeichnet, daß** Ln3 Cer darstellt.

6. Mischoxid nach einem der Ansprüche 1 bis 5, **dadurch gekennzeichnet, daß** y2 der Beziehung $0,02 \leq y2 \leq 0,6$ genügt.

7. Mischoxid nach Anspruch 1, **dadurch gekennzeichnet**, **daß** es durch die Formel

$$Sr_xLn2_{y2}Mg_zAl_aO_{19-k}$$

dargestellt wird.

8. Mischoxid nach einem der Ansprüche 1 bis 7, **dadurch gekennzeichnet, daß** Ln2 Neodym darstellt.

9. Mischoxid nach einem der Ansprüche 1 bis 7, **dadurch gekennzeichnet, daß** Ln2 Praseodym darstellt.

10. Mischoxid nach Anspruch 1, **dadurch gekennzeichnet**, **daß** es durch die Formel

$$Sr_xLn1_{y1}Nd_{y2}Mg_zAl_aO_{19-k}$$

dargestellt wird und Ln1 Lanthan oder Gadolinium darstellt und $y1 = 0$ ist.

11. Mischoxid nach einem der Ansprüche 7 bis 10, **dadurch gekennzeichnet, daß** $k = 0$ ist.

12. Mischoxid nach einem der Ansprüche 1 bis 11, **dadurch gekennzeichnet, daß** $0,5 \leq x + y1 + y2 + y3 \leq 1$ ist.

13. Mischoxid nach einem der Ansprüche 1 bis 12, **dadurch gekennzeichnet, daß** $0 \leq y1 \leq 0,9$ ist.

14. Mischoxid nach einem der Ansprüche 1 bis 13, **dadurch gekennzeichnet, daß** $0 \leq y3 \leq 0,6$ ist.

15. Mischoxid nach einem der Ansprüche 1 bis 14, **dadurch gekennzeichnet, daß** $0,05 \leq x \leq 0,95$ ist.

16. Mischoxid nach einem der Ansprüche 1 bis 15, **dadurch gekennzeichnet, daß** $0,05 \leq z \leq 0,8$ ist.

17. Laser mit einem Laserhohlraum (2, 15), der als Lichtquelle einen Monokristall (4, 16) aus einem Lanthanid-Mischoxid einschließt, Verstärkungsvorrichtungen (10 , 12, 26, 30) für das von dem Monokristall ausgesendeten Licht, Entnahmevorrichtungen (10, 30) für das Licht aus dem Laserhohlraum und optische Pumpvorrichtungen (6, 18, 20), **dadurch gekennzeichnet, daß** das Mischoxid einem der Ansprüche 1 bis 16 entspricht.

18. Laser nach Anspruch 17, der im Infraroten emittiert, **dadurch gekennzeichnet, daß** Ln 2 ein Element darstellt ausgewählt aus Neodym, Holmium, Erbium und Thulium.

19. Laser nach Anspruch 17, der im sichtbaren Bereich emittiert, **dadurch gekennzeichnet, daß** Ln2 Praseodym darstellt.

20. Laser nach Anspruch 17, dessen Wellenlänge im Infraroten abstimmbar ist, der Abstimmvorrichtungen (14, 40) umfaßt, **dadurch gekennzeichnet, daß** Ln2 ein Element darstellt, ausgewählt aus Neodym, Holmium, Thulium und Erbium.

17

**21.** Laser nach einem der Ansprüche 17 bis 20, **dadurch gekennzeichnet, daß** $0{,}05 \leqq y2 \leqq 0{,}45$ ist.

**22.** Laser nach einem der Ansprüche 17 bis 21, **dadurch gekennzeichnet, daß** $0{,}15 \leqq y2 \leqq 0{,}25$ ist.

**23.** Laser nach einem der Ansprüche 17 bis 22, **dadurch gekennzeichnet, daß** die optischen Pumpvorrichtungen (6) aus wenigstens einem Diodenlaser bestehen.

**24.** Laser nach Anspruch 17, **dadurch gekennzeichnet, daß** Ln2 Neodym darstellt und daß die optischen Pumpvorrichtungen (6) aus wenigstens einem Diodenlaser bestehen, der bei 800 nm emittiert.

FIG. 1

FIG. 2

FIG. 3

FIG. 4

FIG. 5

FIG. 6

EP 0 451 001 B1

FIG. 7

EP 0 451 001 B1